# EUROPÄISCHE PATENTANMELDUNG

(11) **EP 0 939 432 A1**
(43) Veröffentlichungstag der Anmeldung: **01.09.1999**
(21) Anmeldenummer: 98102789.9
(22) Anmeldetag: 17.02.1998
(51) Int. Cl.: H01L 21/3105, H01L 21/762

(54) **Verfahren zum Entwurf einer Maske zur Herstellung eines Dummygebiets in einem Isolationsgrabengebiet zwischen elektrisch aktiven Gebieten einer mikroelektronischen Vorrichtung**

(71) Anmelder: SIEMENS AKTIENGESELLSCHAFT, 80333 München (DE)
(72) Erfinder: Ludwig, Burkhard, 81379 München (DE); Weis, Rolf, 01099 Dresden (DE); Thiele, Jörg, 80636 München (DE); Zehner, Sigurd, 01129 Dresden (DE); Scholz, Arnd, 01159 Dresden (DE)

(57) **Zusammenfassung**

Die vorliegende Erfindung schafft ein Verfahren zum Entwurf einer Maske zur Herstellung mindestens eines in ein Dummygrabengebiet (D1L', D1L'', D1L'''; DL; L) und in ein Dummystützgebiet (D1S; D2S; D3S; S, S'; D'S) strukturierten Dummygebiets (D1; D2; D3; D; D') in einem Isolationsgrabengebiet zwischen elektrisch aktiven Gebieten (A; A') einer mikroelektronischen Vorrichtung mit den Schritten: Festlegen der aktiven Gebiete (A; A') und des dazwischenliegenden Isolationsgrabengebiets; Festlegen eines Isolationsgrabensaums (IS) in der Peripherie der aktiven Gebiete (A; A') im Isolationsgrabengebiet, und eines möglichen weiteren Gebiets im Isolationsgrabengebiet, innerhalb derer kein Dummygebiet (D1; D2; D; D') erlaubt ist, in Abhängigkeit vom verwendeten Herstellungsprozeß und der elektrischen Funktion der aktiven Gebiete (A; A'); Festlegen des Dummygebiets (D1; D2; D3; D; D') im Isolationsgrabengebiet als Komplement des Gebiets oder der Gebiete, innerhalb dessen oder derer kein Dummygebiet (D1; D2; D3; D; D') erlaubt ist; und Strukturieren des Dummygebiets (D1; D2; D3; D; D') in das Dummygrabengebiet (D1L', D1L'', D1L'''; DL; L) und das Dummystützgebiet (D1S; D2S; D3S; S, S'; D'S) in Abhängigkeit vom verwendeten Herstellungsprozeß.

## Beschreibung

Die vorliegende Erfindung betrifft ein Verfahren zum Entwurf einer Maske zur Herstellung mindestens eines, in ein Dummygrabengebiet und in ein Dummystützgebiet strukturierten Dummygebiets in einem Isolationsgrabengebiet zwischen elektrisch aktiven Gebieten einer mikroelektronischen Vorrichtung. Insbesondere betrifft die Erfindung ein Verfahren zum Entwurf einer IT(Isolation Trench)-Maske zur Herstellung von Dummygebieten in Isolationsgräben zwischen elektrisch aktiven Gebieten einer mikroelektronischen Vorrichtung für den Prozeß einer maskenlose STI(Shallow Trench Isolation)-Planarisierung.

Unter aktiven Gebieten einer mikroelektronischen Vorrichtung sollen dabei Gebiete verstanden werden, welche eine vorbestimmte elektrische Funktion aufweisen, wie z.B. Leiterbahnen, Dioden, Transistoren, Speicherzellen oder komplexere Schaltungsvorrichtungen.

Die Dummygebiete hingegen erfüllen keine vorbestimmte elektrische Funktion, sondern dienen lediglich zum Vorsehen von Dummystützstrukturen und Dummygrabenstrukturen, welche prozeßtechnische Vorteile bei der Herstellung der mikroelektronischen Vorrichtung bieten. Dabei bedeutet der Begriff Dummygebiet also zunächst, daß in diesem Gebiet prinzipiell Dummystützen und Dummygraben vorsehbar sind. Daß nicht im gesamten Isolationsgrabengebiet Dummystützen und Dummygräben vorsehbar sind, liegt an bestimmten funktionellen Randbedingungen, welche später erläutert werden.

Obwohl prinzipiell auf beliebige aktive Gebiete einer beliebigen mikroelektronischen Vorrichtung anwendbar, werden die vorliegende Erfindung sowie die ihr zugrundeliegende Problematik in bezug auf in einem Siliziumsubstrat vorgesehene Gräben zwischen darin vorgesehenen aktiven Berichen erläutert.

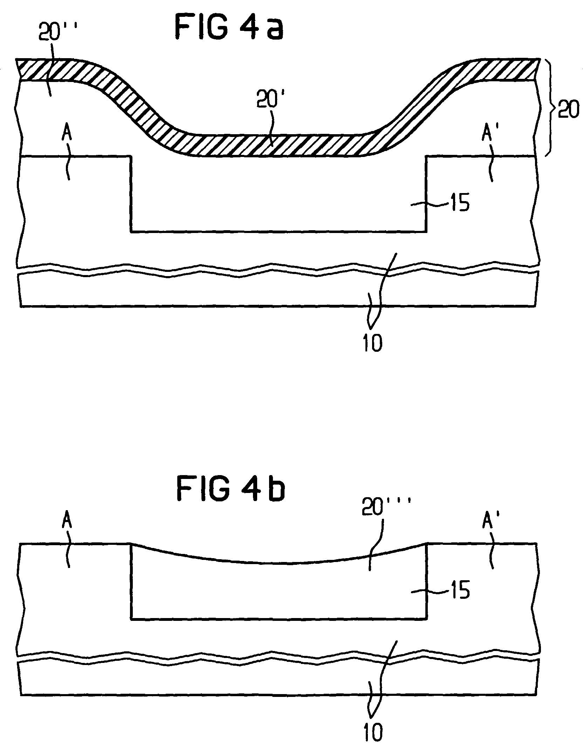

Fig. 4a und 4b zeigen eine schematische Darstellung eines ersten Prozeßablaufs zur Auffüllung eines Isolationsgrabengebiets zwischen zwei elektrisch aktiven Gebieten.

In Fig. 4a und 4b bezeichnen 10 ein Halbleitersubstrat, 15 einen Isolationsgraben, 20 eine Oxidschicht, 20' einen rückgeätzten Bereich der Oxidschicht 20, 20'' einen nach dem Rückätzen stehengeblieben Bereich der Oxidschicht 20, 20''' einen nach einem chemisch-mechanischen Polieren stehengeblieben Bereich der Oxidschicht 20 und A, A' elektrisch aktive Gebiete.

Bei diesem ersten Prozeßablauf wird zunächst eine Maske für den Isolationsgraben-Herstellungsschritt erstellt. Mittels dieser Maske wird der Isolationsgraben auf dem Siliziumsubstrat 10 photolithographisch strukturiert und geätzt. Dann wird die Oxidschicht 20 (vorzugsweise TEOS = thermisches Oxid) aufgewachsen und der Bereich 20' rückgeätzt. Schließlich erfolgt das chemisch-mechanische Polieren, welches die in Fig. 4b gezeigte Struktur mit dem stehengebliebenen Bereich 20''' ergibt.

Die der vorliegenden Erfindung zugrundeliegende Problematik besteht allgemein darin, daß der Bereich 20''' eine nach unten gerichtete konkave Form aufweist, was üblicherweise als Dishing bezeichnet wird. Diese Form rührt daher, daß die Polierscheibe aufgrund der unebenen Oberfläche Material aus dem Isolationsgraben 15 herauslöst. Die Stärke dieses Dishing hängt insbesondere von der Breite bzw. dem Durchmesser des Isolationsgrabens 15 ab.

Momentan sind zwei prinzipielle Ansätze zur Lösung dieses Problems üblich.

Einerseits kann in einem zusätzlichen Photolithographieschritt das über dem Isolationsgraben 15 liegende Gebiet mit zusätzlichem Lack abgedeckt werden. Beim anschließenden Rückätzen wird dann der Lack genauso wie das Oxid geätzt. Vor dem chemisch-mechanischen Polieren findet man aber eine wesentlich glattere bzw. ebenere Oberfläche vor, so daß der Dishing-Effekt stark reduziert ist. Allerdings ist dieses Verfahren aufwendig, da es eine zusätzliche Maskenebene erfordert.

Andererseits ist es möglich, die Planarisierung ohne eine zusätzliche Maskenebene zu verbessern, wenn man in den Isolationsgraben 15 eine zusätzliche Dummystützstruktur einfügt, die dem Eingraben der Polierscheibe in das im Isolationsgraben 15 befindliche Oxid 20 entgegenwirkt.

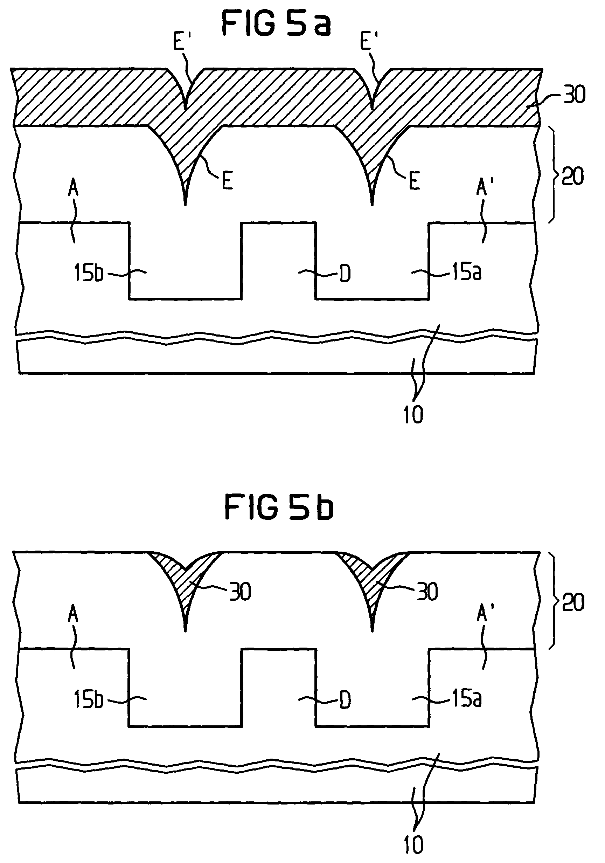

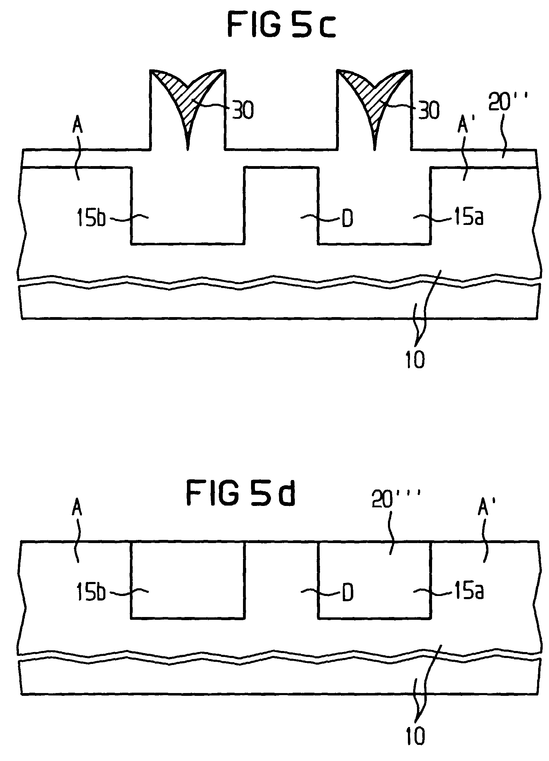

Fig. 5a bis 5d zeigen eine schematische Darstellung eines zweiten Prozeßablaufs zur Auffüllung eines Isolationsgrabengebiets zwischen zwei elektrisch aktiven Gebieten, wobei eine zusätzliche Dummystützstruktur vorgesehen wird und keine zusätzliche Maskenebene erforderlich ist (maskenlose STI-Planarisierung).

In Fig. 5a bis 5d bezeichnen 10 ein Halbleitersubstrat, 15a, 15b einen jeweiligen Isolationsgraben, D eine Dummystützstruktur (im einfachsten Fall eine zusätzliche Grabenwand), 20 eine Oxidschicht, 30 eine Polysiliziumschicht, 20'' einen nach dem Rückätzen stehengeblieben Bereich der Oxidschicht 20, 20''' einen nach dem chemisch-mechanischen Polieren stehengeblieben Bereich der Oxidschicht 20 und A, A' elektrisch aktive Gebiete sowie E, E' Einsenkungen.

Bei diesem zweiten Prozeßablauf wird zunächst eine Maske für den Isolationsgraben-Herstellungsschritt erstellt. Dabei ist die Maske gegenüber Fig. 4a und 4b derart geändert, daß die Dummystützstruktur D in der Mitte vorgesehen wird, so daß der breite Isolationsgraben 15 von Fig. 4a und 4b in zwei schmalere Isolationsgräben 15a, 15b unterteilt ist. Mittels dieser geänderten Maske werden die Isolationsgräben 15a, 15b in dem Halbleitersubstrat 10 photolithographisch strukturiert und geätzt.

Dann werden die Oxidschicht 20 (vorzugsweise TEOS = thermisches Oxid) aufgewachsen und auf der Oxidschicht 20 die Polysiliziumschicht 30 aufgebracht. Dabei werden die in der Oxidschicht 20 gebildeten Einsenkungen E aufgefüllt und nur wesentlich flachere Einsenkungen E' in der Polysiliziumschicht 30 gebildet. Die Polysiliziumschicht 30 wird dann bis hinab zur oberen Oberfläche der Oxidschicht 20 abpoliert, wobei die Einsenkungen E der Oxidschicht 20 mit der Polysiliziumschicht 30 gefüllt bleiben, wie in Fig. 5b gezeigt.

Dann erfolgt ein anisotropes Rückätzen der Oxidschicht 20 mit hoher Selektivität gegenüber der Polysiliziumschicht 30, so daß unter dem Polysilizium das Oxid im wesentlichen stehenbleibt.

Schließlich erfolgt ein chemisch-mechanisches Polieren, welches die in Fig. 5d gezeigte Struktur mit dem stehengebliebenen Bereich 20''' ergibt, welcher im wesentlichen kein Dishing zeigt.

Als problematisch bei dem obigen bekannten Ansatz hat sich die Tatsache herausgestellt, daß die Gestalt der Dummystützstruktur bestimmten Randbedingungen unterliegt. Mit anderen Worten können aufgrund der bereits angesprochenen funktionellen Randbedingungen nicht überall im Isolationsgraben Dummystützen vorgesehen werden.

Insbesondere ist die Dummystützstruktur von etwaigen in der darüberliegenden Maskenebene und etwaigen in der darunterliegenden Maskenebene vorgesehenen aktiven Gebieten bzw. Dummygebieten abhängig.

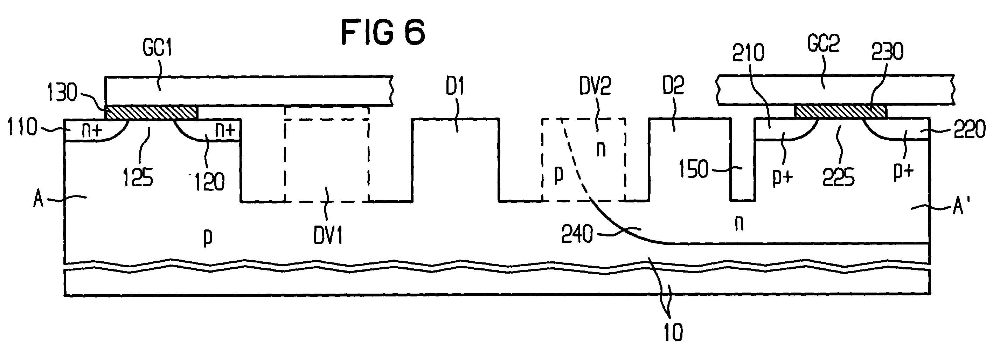

Fig. 6 zeigt eine schematische Darstellung zur Erläuterung der Randbedingungen, welche an eine Dummystützstruktur von etwaigen in der darüberliegenden Maskenebene und etwaigen in der darunterliegenden Maskenebene vorgesehenen aktiven Gebieten bzw. Dummygebieten gestellt werden können.

In Fig. 6 bezeichnen 10 ein Halbleitersubstrat mit p-Dotierung, A, A' ein erstes und zweites elektrisch aktives Gebiet, welche jeweils einen Feldeffekttransistor aufweisen, und 150 ein Isolationsgrabengebiet, d.h. ein Gebiet, das prinzipiell ein zusammenhängender Graben sein könnte, wenn keine Dummystützstrukturen prozeßtechnisch erfoderlich wären.

Der Feldeffekttransistor im ersten elektrisch aktiven Gebiet A umfaßt einen n⁺-dotierten Drainbereich 110, einen n⁺-dotierten Sourcebereich 120, einen Kanalbereich 125 mit der p-Dotierung des Halbleitersubstrats 10, einen Gateisolationsbereich 130 und einen Gateanschlußleiterbahnbereich GC1.

Der Feldeffekttransistor im zweiten elektrisch aktiven Gebiet A' umfaßt einen p⁺-dotierten Drainbereich 210, einen p⁺-dotierten Sourcebereich 220, einen Kanalbereich 125 mit der n-Dotierung einer im Halbleitersubstrat 10 eingebrachten n-Wanne 240, einen Gateisolationsbereich 230 und einen Gateanschlußleiterbahnbereich GC2.

Im Isolationsgrabenbereich 150 sind zwei verbotene Gebiete für eine Dummystützstruktur DV1, DV2 und zwei erlaubte Gebiete für eine Dummystützstruktur D1, D2 angedeutet.

Das erste verbotene Gebiet DV1 befindet sich unter dem Gateanschlußleiterbahnbereich GC1 und das zweite verbotene Gebiet DV2 befindet sich auf der Grenze der n-Wanne 240. Wäre hier jeweils eine Dummystützstruktur vorgesehen, so resultierte dies in entsprechenden parasitären aktiven Bauelementen, die die Funktion der vorgesehenen aktiven Gebiete stören könnten.

Außerdem ist die Dichte der Dummystruktur, d.h. das Verhältnis von unausgefüllten Flächen (Stützen) zu gefüllten Flächen (Gräben), nicht beliebig wählbar, sondern unterliegt engen Grenzen. Werden diese Grenzen nicht beachtet, kommt es zu lokalen Variationen des Polierabtrags und somit zu schlechten Prozeßresultaten.

Daher ist es Aufgabe der vorliegenden Erfindung, ein einfaches Verfahren zum Entwurf einer Maske zur Herstellung mindestens eines in ein Dummygrabengebiet und in ein Dummystützgebiet strukturierten Dummygebiets in einem Isolationsgrabengebiet zwischen elektrisch aktiven Gebieten einer mikroelektronischen Vorrichtung anzugeben, das eine Erfüllung der jeweiligen, vom Prozeß und den elektrischen Funktionseinheiten auferlegten Randbedingungen gewährleisten und gleichzeitig eine optimale Dichte der Dummystützstruktur liefern kann.

Erfindungsgemäß wird diese Aufgabe durch das in Anspruch 1 angegebene Verfahren gelöst, also durch ein Verfahren zum Entwurf einer Maske zur Herstellung mindestens eines in ein Dummygrabengebiet und in ein Dummystützgebiet strukturierten Dummygebiets in einem Isolationsgrabengebiet zwischen elektrisch aktiven Gebieten einer mikroelektronischen Vorrichtung mit den Schritten: Festlegen der aktiven Gebiete und des dazwischenliegenden Isolationsgrabengebiets; Festlegen eines Isolationsgrabensaums in der Peripherie der aktiven Gebiete im Isolationsgrabengebiet, und eines möglichen weiteren Gebiets im Isolationsgrabengebiet, innerhalb derer kein Dummygebiet erlaubt ist, in Abhängigkeit vom verwendeten Herstellungsprozeß und der elektrischen Funk- tion der aktiven Gebiete; Festlegen des Dummygebiets im Isolationsgrabengebiet als Komplement des Gebiets oder der Gebiete, innerhalb dessen oder derer kein Dummygebiet erlaubt ist; und Strukturieren des Dummygebiets in das Dummygrabengebiet und das Dummystützgebiet in Abhängigkeit vom verwendeten Herstellungsprozeß.

Das erfindungsgemäße Verfahren weist gegenüber den bekannten Lösungsansätzen den Vorteil auf, daß es in gewissen Fällen aufgrund der möglichen engen Packungsdichte der Dummystützstruktur einen direkten Polierprozeß ohne Rückätzung möglich macht. Jedenfalls können die Dummystützstrukturen für das jeweils verwendete Planarisierungverfahren optimiert werden und funktionelle Randbedingungen strikt eingehalten werden.

Die der vorliegenden Erfindung zugrundeliegende Idee besteht darin, daß der Dummybereich mit der angegebenen Systematik den Umständen entsprechend optimal gestaltet wird.

In den Unteransprüchen finden sich vorteilhafte Weiterbildungen und Verbesserungen des in Anspruch 1 angegebenen Verfahrens.

Gemäß einer bevorzugten Weiterbildung erfolgen ein Festlegen mindestens eines über dem Isolationsgrabengebiet verlaufenden Leiterbahngebiets und ein Festlegen eines Saumgebiets unterhalb der Peripherie des Leiterbahngebiets im Isolationsgrabengebiet, innerhalb dessen kein Dummygebiet erlaubt ist. So ist es möglich, ein in der darüberliegenden Maskenebene vorgesehenes aktives Gebiet bzw. Dummygebiet bei der Erstellung der Maske zu berücksichtigen.

Gemäß einer weiteren bevorzugten Weiterbildung erfolgen ein Festlegen mindestens eines unter dem Isolationsgrabengebiet verlaufenden Wannengebiets und ein Festlegen eines Saumgebiets oberhalb der Peripherie des Wannengebiets im Isolationsgrabengebiet, innerhalb dessen kein Dummygebiet erlaubt ist. So ist es möglich, ein in der darunterliegenden Maskenebene vorgesehenes aktives Gebiet bzw. Dummygebiet bei der Erstellung der Maske zu berücksichtigen.

Gemäß einer weiteren bevorzugten Weiterbildung erfolgt der Schritt des Strukturierens des Dummygebiets in das Dummygrabengebiet und das Dummystützgebiet durch Festlegen einer Mehrzahl nicht-zusammenhängender Stützen als das Dummystützgebiet und durch Festlegen des zwischen den Stützen liegenden zusammenhängenden Gebiets als das Dummygrabengebiet.

Gemäß einer weiteren bevorzugten Weiterbildung werden die Stützen derart regelmäßig angeordnet, daß von der Umhüllenden des Dummygebiets eine oder mehrere Stützen geschnitten werden und die geschnittene(n) Stütze(n) aus dem Dummystützgebiet entfernt. Damit gibt es keine Stützen mit unregelmäßger Geometrie, welche elektrische Fehlfunktionen hervorrufen könnten.

Gemäß einer weiteren bevorzugten Weiterbildung erfolgt der Schritt des Strukturierens des Dummygebiets in das Dummygrabengebiet und das Dummystützgebiet durch Festlegen einer Mehrzahl nicht-zusammenhängender Gräben als das Dummygrabengebiet und durch Festlegen des zwischen den Gräben liegenden zusammenhängenden Gebiets als das Dummystützgebiet. Der Begriff Graben soll dabei selbstverständlich jegliche Art von lochartigen Gebilden mitbeinhalten.

Gemäß einer weiteren bevorzugten Weiterbildung werden die Gräben regelmäßig angeordnet und wird die Umhüllende des Dummygebiets derart in eine korrigierte Umhüllende umgewandelt wird, daß das zusammenhängende Gebiet gegenüber der ursprünglichen Umhüllenden zurückversetzt ist. Damit gibt es keinen Stützbereich mit unregelmäßger Geometrie, welcher elektrische Fehlfunktionen hervorrufen könnten.

Gemäß einer weiteren bevorzugten Weiterbildung wird die korrigierte Umhüllende aus einer Mehrzahl gerader Abschnitte gebildet, die jeweils einen bestimmten Winkel miteinander bilden.

Gemäß einer weiteren bevorzugten Weiterbildung wird der Winkel jeweils im wesentlichen zu 90° ausgebildet. Selbstverständlich kann es jedoch Designs geben, welche einen anderen charakteristischen Winkel erfordern.

Gemäß einer weiteren bevorzugten Weiterbildung erfolgt beim Schritt des Strukturierens des Dummygebiets in das Dummygrabengebiet und das Dummystützgebiet ein Festlegen des Verhältnisses des Dummygrabengebiets und das Dummystützgebiets.

Ausführungsbeispiele der Erfindung sind in den Zeichnungen dargestellt und in der nachfolgenden Beschreibung näher erläutert.

Es zeigen:
- Fig. 1: eine schematische Darstellung zum Illustrieren einer Ausführungsform der erfindungsgemäßen Verfahrens;
- Fig. 2: eine schematische Darstellung zum Illustrieren einer ersten bevorzugten Variante der Strukturierung des Dummygebiets bei der Ausführungsform der erfindungsgemäßen Verfahrens;
- Fig. 3: eine schematische Darstellung zum Illustrieren einer zweiten bevorzugten Variante der Strukturierung des Dummygebiets bei der Ausführungsform der erfindungsgemäßen Verfahrens;
- Fig. 4a und b: eine schematische Darstellung eines ersten Prozeßablaufs zur Auffüllung eines Isolationsgrabengebiets zwischen zwei elektrisch aktiven Gebieten;
- Fig. 5a bis 5d: zeigen eine schematische Darstellung eines zweiten Prozeßablaufs zur Auffüllung eines Isola-tionsgrabengebiets zwischen zwei elektrisch aktiven Gebieten, wobei eine zusätzliche Dummystützstruktur vorgesehen wird; und
- Fig. 6: eine schematische Darstellung zur Erläuterung der Randbedingungen, welche an eine Dummystützstruktur von etwaigen in der darüberliegenden Maskenebene und etwaigen in der darunterliegenden Maskenebene vorgesehenen aktiven Bereichen bzw. Dummybereichen gestellt werden können.

In den Figuren bezeichnen gleiche Bezugszeichen gleiche oder funktionsgleiche Elemente.

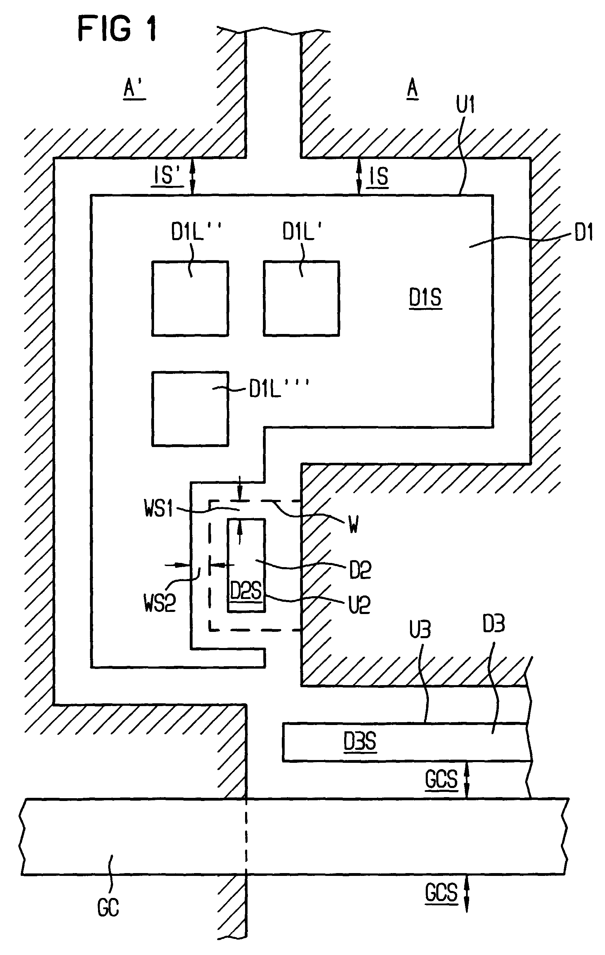

Fig. 1 ist eine schematische Darstellung zum Illustrieren einer Ausführungsform der erfindungsgemäßen Verfahrens.

In Fig. 1 bezeichnen A, A' ein erstes und ein zweites aktives Gebiet, IS einen Isolationsgrabensaum des ersten aktiven Gebiets A, IS' einen Isolationsgrabensaum des zweiten aktiven Gebiets A', D1, D2, D3 ein jeweiliges Dummygebiet mit einer entsprechenden Umhüllenden U1, U2, U3 und einem darin enthaltenen Dummystützgebiet D1S, D2S, D3S, wobei D1L', D1L'' und D1L''' Dummygrabengebiete des Dummygebiets D1 sind. Weiterhin bezeichnet W einen Rand einer unter der betreffenden Maskenebene liegenden Wanne, WS1 und WS2 einen jeweiligen Wannensaum, GC eine über der betreffenden Maskenebene liegende Gateanschlußleiterbahn und GCS einen Gateanschlußleiterbahnsaum.

Im folgenden wird die Ausführungsform der erfindungsgemäßen Verfahrens, welche in Zusammenhang mit Fig. 1 steht, näher erläutert.

Zunächst erfolgt ein Festlegen der aktiven Gebiete A, A' und des dazwischenliegenden Isolationsgrabengebiets. Danach wird ein Isolationsgrabensaum IS bzw. IS' in der Peripherie der beiden aktiven Gebiete A, A' im Isolationsgrabengebiet in Abhängigkeit vom verwendeten Herstellungsprozeß und der elektrischen Funktion der aktiven Gebiete festgelegt. Im betrachteten Fall ist dies einfach ein Streifen bestimmter Breite, welcher angrenzend an die aktiven Gebiete A, A' als Graben reserviert wird. Im gezeigten Fall ist dieser Streifen an den Eckpunkten zur Vereinfachung der Geometrie leicht verbreitert bzw. geglättet.

Als nächstes werden weitere Gebiete im Isolationsgrabengebiet festgelegt, innerhalb derer kein Dummygebiet erlaubt ist, und zwar wiederum in Abhängigkeit vom verwendeten Herstellungsprozeß und der elektrischen Funktion der aktiven Gebiete.

Dazu wird die über dem Isolationsgrabengebiet verlaufende Gateanschlußleiterbahn GC herangezogen und ein Saumgebiet GCS unterhalb der Peripherie der Gateanschlußleiterbahn im Isolationsgrabengebiet festgelegt, innerhalb dessen kein Dummygebiet erlaubt ist.

Als nächstes erfolgt das Festlegen des unter dem Isola-tionsgrabengebiet verlaufenden Wannengebiets mit dem Rand W und das Festlegen eines entsprechenden Saumgebiets WS1, WS2 oberhalb der Peripherie des Wannengebiets W im Isolationsgrabengebiet, innerhalb dessen ebenfalls kein Dummygebiet erlaubt ist.

In der Praxis läßt sich dieser Bereich einfach dadurch ausblenden, daß man beispielsweise durch Aufblähen und Verkleinern der Implantationsmaske Streifen um die Implantationsgrenzen entsprechend der Differenz der Strukturen erzeugt, die zum verbotenen Gebiet hinzugenommen werden.

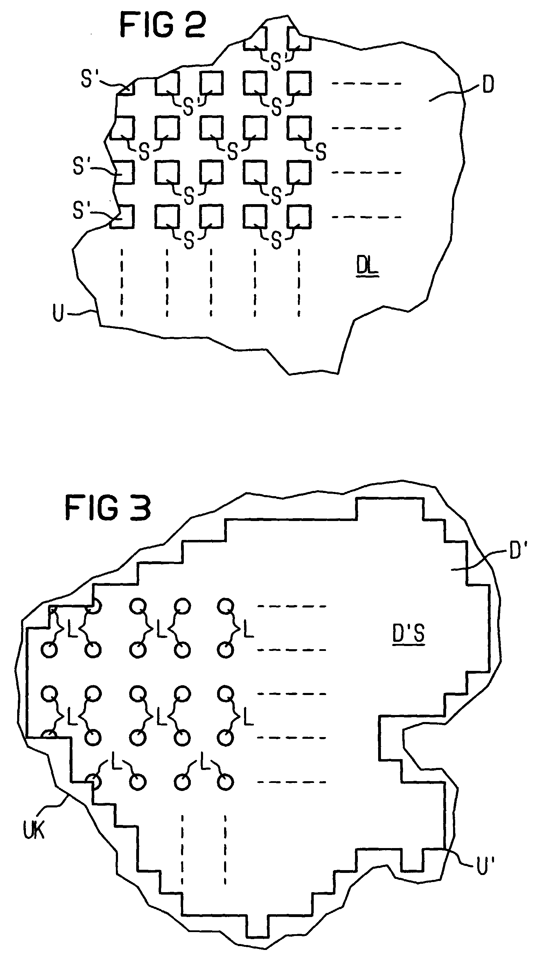

Das Dummygebiet im Isolationsgrabengebiet wird als Komplement der Gebiete, innerhalb derer kein Dummygebiet erlaubt ist, festgelegt, bei dieser Ausführungsform als die Gebiete D1, D2 und D3. Der nächste Schritt sieht das Strukturieren des festgelegten Dummygebiets D1, D2, D3 in das jeweilige Dummygrabengebiet D1L', D1L'', D1L''' (hier nur bei D1) und das jeweilige Dummystützgebiet D1S, D2S, D3S in Abhängigkeit vom verwendeten Herstellungsprozeß vor. Dabei steht offen, die entstandenen Dummygebiete durch einen Musterfüllalgorithmus mit Reihen oder Gittern von kleinen Figuren gleicher Gestalt (z.B. Kreise, Quadrate, Dreiecke o.ä.) als nicht-zusammenhängende Stützelemente aufzufüllen oder eine zusammenhängende Stützstrukur zunächst als durchlöcherten Block vorzusehen (inverse Cheese-Maske). Dies wird nachstehend mt Bezug auf Fig. 2 und 3 näher erläutert.

Damit sind die grundlegenden Schritte zur Erstellung der Maske durchgeführt.

Es sei noch bemerkt, daß es zweckmäßig ist, die betreffenden Geometrien, Abstände und Randbedingungen in Form von Designregeln im verwendeten Maskengenerator zu speichern.

Fig. 2 ist eine schematische Darstellung zum Illustrieren einer ersten bevorzugten Variante der Strukturierung des Dummygebiets bei der Ausführungsform der erfindungsgemäßen Verfahrens.

In Fig. 2 bezeichnen U die festgelegte Umhüllende des Dummybereichs D, DL das Dummygrabengebiet und S, S' das Dummystützgebiet.

Bei dieser ersten Variante erfolgt zunächst ein Festlegen einer Mehrzahl nicht-zusammenhängender Stützen S, S' gemäß einem bestimmten Algorithmus, gemäß dem die Stützen S, S' regelmäßig angeordnet werden, und dann ein Festlegen des zwischen den Stützen S, S' liegenden zusammenhängenden Gebiets DL als das komplementäre Dummygrabengebiet DL.

Dabei werden, wie aus Fig. 2 ersichtlicht, von der Umhüllenden U des Dummygebiets D die Stützen S' geschnitten. Um unregelmäßige Stützelemente zu vermeiden, werden die geschnittenen Stützen S' zweckmäßigerweise noch aus dem Dummystützgebiet entfernt.

Fig. 3 ist eine schematische Darstellung zum Illustrieren einer zweiten bevorzugten Variante der Strukturierung des Dummygebiets bei der Ausführungsform der erfindungsgemäßen Verfahrens.

In Fig. 3 bezeichnen U' die festgelegte Umhüllende des Dummybereichs D', Uk eine korrigierte Umhüllende des Dummybereichs D', L das Dummygrabengebiet und D'S das Dummystützgebiet.

Bei dieser zweiten Variante erfolgt prinzipiell zunächst ein Festlegen einer Mehrzahl nicht-zusammen-hängender Gräben bzw. Löcher L als das Dummygrabengebiet gemäß einem bestimmten Algorithmus, gemäß dem die Gräben L regelmäßig angeordnet werden, und dann ein Festlegen des zwischen den Gräben L liegenden zusammenhängenden Gebiets D'S als das komplementäre Dummystützgebiet.

Für diese zweite Variante ist es besonders wichtig, daß die dem Algorithmus als Parameter zugrundeleigende Umhüllende nicht direkt als Dummystützbereich verwendet wird, da sie eine sehr subtile Struktur aufweisen kann, welche bestimmte allgemeine Designregeln verletzten kann (z.B. Vermeidung von Spitzen wegen der damit verbundenen hohen Feldstärke).

Daher wird die Umhüllende U' des Dummygebiets D' derart in eine korrigierte Umhüllende Uk umgewandelt, welche aus groberen Elementen besteht, daß das resultierende zusammenhängende Gebiet D'S gegenüber der ursprünglichen Umhüllenden U' zurückversetzt ist. Insbesondere wird im vorliegenden Fall die korrigierte Umhüllende Uk aus einer Mehrzahl gerader Abschnitte gebildet, die jeweils mit einem Winkel von im wesentlichen 90° zueinander ausgebildet sind.

Schließlich sei noch bemerkt, daß in Abhängigkeit vom verwendeten Prozeß das Verhältnis des Dummygrabengebiets und dss Dummystützgebiets für jedes Dummygebiet geeignet festgelegt wird.

Obwohl die vorliegende Erfindung vorstehend anhand bevorzugter Ausführungsbeispiele beschrieben wurde, ist sie darauf nicht beschränkt, sondern auf vielfältige Art und Weise modifizierbar.

Obwohl bei der oben erörterten Ausführungsform das Dummygebiet unter Berücksichtigung der verbotenen Gebiete um die aktiven Gebiete, um die Gateanschlußleiterbahnen und um die Wannenränder herum festgelegt wurde, ist es selbstverständlich möglich, weitere Randbedingungen für die Festlegung des Dummygebiets heranzuziehen.

Auch ist eine nahezu beliebige geometrische Strukturierung der Dummygebiete in Dummygrabengebiete und Dummystützgebiete unter Berücksichtigung der Eigenheiten des jeweiligen Prozesses möglich.

Anstelle der Oxidschicht 20 kann selbstverständlich eine beliebige Isolationsschicht, wie z.B. eine Hochdruck-Plasma-Isolationsschicht verwendet werden.

Eine weitere bevorzugte Anwendung der vorliegenden Erfindung liegt in der bzw. den Metallisierungsebenen.

## Patentansprüche

1. Verfahren zum Entwurf einer Maske zur Herstellung mindestens eines in ein Dummygrabengebiet (D1L', D1L'', D1L'''; DL; L) und in ein Dummystützgebiet (D1S; D2S; D3S; S, S'; D'S) strukturierten Dummygebiets (D1; D2; D3; D; D') in einem Isolationsgrabengebiet zwischen elektrisch aktiven Gebieten (A; A') einer mikroelektronischen Vorrichtung mit den Schritten:
Festlegen der aktiven Gebiete (A; A') und des dazwischenliegenden Isolationsgrabengebiets;
Festlegen eines Isolationsgrabensaums (IS; IS') in der Peripherie der aktiven Gebiete (A; A') im Isolationsgrabengebiet, und eines möglichen weiteren Gebiets im Isolationsgrabengebiet, innerhalb derer kein Dummygebiet (D1; D2; D3; D; D') erlaubt ist, in Abhängigkeit vom verwendeten Herstellungsprozeß und der elektrischen Funktion der aktiven Gebiete (A; A');
Festlegen des Dummygebiets (D1; D2; D3; D; D') im Isolationsgrabengebiet als Komplement des Gebiets oder der Gebiete, innerhalb dessen oder derer kein Dummygebiet (D1; D2; D3; D; D') erlaubt ist; und
Strukturieren des Dummygebiets (D1; D2; D3; D; D') in das Dummygrabengebiet (D1L', D1L'', D1L'''; DL; L) und das Dummystützgebiet (D1S; D2S; D3S; S, S'; D'S) in Abhängigkeit vom verwendeten Herstellungsprozeß.

2. Verfahren nach Anspruch 1,
**gekennzeichnet** durch die Schritte:
Festlegen mindestens eines über dem Isolationsgrabengebiet verlaufenden Leiterbahngebiets (GC);
Festlegen eines Saumgebiets (GCS) unterhalb der Peripherie des Leiterbahngebiets (GC) im Isolationsgrabengebiet, innerhalb dessen kein Dummygebiet (D1; D2; D3; D; D') erlaubt ist.

3. Verfahren nach Anspruch 1 oder 2,
**gekennzeichnet** durch die Schritte:
Festlegen mindestens eines unter dem Isolationsgrabengebiet verlaufenden Wannengebiets (W);
Festlegen eines Saumgebiets (WS1, WS2) oberhalb der Peripherie des Wannengebiets (W) im Isolationsgrabengebiet, innerhalb dessen kein Dummygebiet (D1; D2; D3; D; D') erlaubt ist.

4. Verfahren nach Anspruch 1, 2 oder 3,
**dadurch gekennzeichnet,** daß der Schritt des Strukturierens des Dummygebiets (D1; D2; D3; D; D') in das Dummygrabengebiet (D1L', D1L'', D1L'''; DL; L) und das Dummystützgebiet (D1S; D2S; D3S; S, S'; D'S) folgende Schritte aufweist:
Festlegen einer Mehrzahl nicht-zusammenhängender Stützen (S, S') als das Dummystützgebiet (D1S; D2S; D3S; S, S'; D'S); und Festlegen des zwischen den Stützen (S, S') liegenden zusammenhängenden Gebiets (DL) als das Dummygrabengebiet (D1L', D1L'', D1L'''; DL; L).

5. Verfahren nach Anspruch 4,
**dadurch gekennzeichnet,** daß die Stützen (S, S') derart regelmäßig angeordnet werden, daß von der Umhüllenden (U) des Dummygebiets (D1; D2; D; D') eine oder mehrere Stützen (S') geschnitten werden; und
die geschnittene(n) Stütze(n) (S') aus dem Dummystützgebiet (D1S; D2S; D3S; S, S'; D'S) entfernt werden.

6. Verfahren nach Anspruch 1, 2 oder 3,
**dadurch gekennzeichnet,** daß der Schritt des Strukturierens des Dummygebiets (D1; D2; D3; D; D') in das Dummygrabengebiet (D1L', D1L'', D1L'''; DL; L) und das Dummystützgebiet (D1S; D2S; D3S; S, S'; D'S) folgende Schritte aufweist:
Festlegen einer Mehrzahl nicht-zusammenhängender Gräben (L) als das Dummygrabengebiet (D1L', D1L'', D1L'''; DL; L); und
Festlegen des zwischen den Gräben (L) liegenden zusammenhängenden Gebiets (D'S) als das Dummystützgebiet (D1S; D2S; D3S; S, S'; D'S).

7. Verfahren nach Anspruch 6,
**dadurch gekennzeichnet,** daß die Gräben (L) regelmäßig angeordnet werden und die Umhüllende (U') des Dummygebiets (D1; D2; D3; D; D') derart in eine korrigierte Umhüllende (Uk) umgewandelt wird, daß das zusammenhängende Gebiet (D'S) gegenüber der ursprünglichen Umhüllenden (U') zurückversetzt ist.

8. Verfahren nach Anspruch 7,
**dadurch gekennzeichnet,** daß die korrigierte Umhüllende (Uk) aus einer Mehrzahl gerader Abschnitte gebildet wird, die jeweils einen charakteristischen Winkel miteinander bilden.

9. Verfahren nach Anspruch 8,
**dadurch gekennzeichnet,** daß der Winkel jeweils im wesentlichen zu 90° ausgebildet wird.

10. Verfahren nach einem der vorhergehenden Ansprüche,
**dadurch gekennzeichnet,** daß der Schritt des Strukturierens des Dummygebiets (D1; D2; D3; D; D') in das Dummygrabengebiet (D1L', D1L'', D1L'''; DL; L) und das Dummystützgebiet (D1S; D2S; D3S; S, S'; D'S) folgenden Schritt aufweist:
Festlegen des Verhältnisses des Dummygrabengebiets (D1L', D1L'', D1L'''; DL; L) und das Dummystützgebiets (D1S; D2S; D3S; S, S'; D'S).
